(19)

**Europäisches Patentamt**
**European Patent Office**
**Office européen des brevets**

(11) **EP 1 640 470 B1**

(12) **EUROPEAN PATENT SPECIFICATION**

(45) Date of publication and mention
of the grant of the patent:
**28.09.2011 Bulletin 2011/39**

(21) Application number: **04745763.5**

(22) Date of filing: **10.06.2004**

(51) Int Cl.:
***C23C 8/36*** (2006.01)

(86) International application number:
**PCT/JP2004/008133**

(87) International publication number:
**WO 2004/111293 (23.12.2004 Gazette 2004/52)**

(54) **NITRIDING METHOD AND DEVICE**

NITRIERVERFAHREN UND -VORRICHTUNG

PROCEDE ET DISPOSITIF DE NITRURATION

(84) Designated Contracting States:
**DE FR GB**

(30) Priority: **13.06.2003 JP 2003169012**

(43) Date of publication of application:
**29.03.2006 Bulletin 2006/13**

(73) Proprietor: **HONDA MOTOR CO., LTD.**
**Tokyo 107-8556 (JP)**

(72) Inventors:
• **TAKEUCHI, Yutaka**
**Hagamachi Hagagun Tochigi 321-3395 (JP)**
• **KARASAWA, Hitoshi**
**Hagamachi Hagagun Tochigi 321-3395 (JP)**
• **KOJIMA, Hideo**
**Hagamachi Hagagun Tochigi 321-3395 (JP)**

(74) Representative: **Taylor, Adam David et al**
**Dehns**
**St. Bride's House**
**10 Salisbury Square**
**London EC4Y 8JD (GB)**

(56) References cited:
DE-A1- 19 815 019      GB-A- 2 100 023
JP-A- 54 025 274       JP-A- 55 014 839
JP-A- 2000 045 061     US-A- 4 309 227
US-A- 4 490 190

• HARRISON W W ET AL: "Powering the analytical glow discharge" FRESENIUS' JOURNAL OF ANALYTICAL CHEMISTRY SPRINGER-VERLAG GERMANY, vol. 355, no. 7-8, August 1996 (1996-08), pages 803-807, XP002524990 ISSN: 0937-0633

## Description

The present invention relates to a nitriding treatment method and a nitriding treatment apparatus for performing a nitriding treatment for a workpiece in a heat treatment furnace.

The nitriding treatment resides in a process in which a surface of a workpiece composed of a steel material is nitrided to form an iron nitride layer, and thus the surface of the workpiece is hardened. The nitriding treatment is widely carried out. A method for the nitriding treatment includes a plasma nitriding treatment in which the plasma heating is performed by means of the glow discharge.

In the case of such a treatment, when the workpiece is cold, the glow discharge becomes unstable. Depending on certain situations, any inconvenience arises such that the arc discharge is caused, and a part of the workpiece surface is melted, and/or it is impossible to apply any uniform nitriding treatment. In particular, when the temperature distribution of the workpiece is nonuniform, it is impossible to obtain satisfactory products, because the degree of advance of nitriding differs depending on the positions of the product.

In view of the above, in order to heat the workpiece quickly and uniformly up to a desired temperature at which the nitriding treatment can be performed stably, a conventional technique is known, which is constructed such that a heating means such as an infrared heater or a graphite cloth heating element is arranged around the workpiece, and the workpiece is heated by using the heating means together with the glow discharge (see, for example, Japanese Laid-Open Patent Publication Nos. 52-82641 and 53-23836).

US-A-4309227 discloses an ion-nitriding process comprising a first step of ion-nitriding a workpiece at a high voltage level of glow discharge and a second step of ion-nitriding at a lower voltage level. A heating element is used to heat the workpiece.

However, for example, when a plurality of workpieces having complicated shapes are simultaneously heated in a heat treatment furnace, it is impossible to obtain any uniform temperature distribution for the workpieces when the glow discharge and the heating means are simply used together as in the conventional technique as described above.

That is, the heat, which is brought about by the glow discharge, is basically generated such that the nitrogen ions, which are produced by the glow discharge, collide with the workpiece surface. However, when the workpiece is heated to be not less than a certain temperature, the surrounding workpieces are heated by the radiation heat of the workpiece itself. Therefore, the difference in temperature appears between the region which is disposed close to the heating means and the region which is disposed separately from the heating means. If a large number of heating means are arranged among the workpieces, this problem can be dissolved. However, it is almost impossible to construct the heating means arranged at appropriate positions among the workpieces in relation to a production line such as those used in the various kinds and small quantity production (job shop type production or flexible manufacturing) in which it is required to perform the nitriding treatment for the workpieces having different shapes.

A general object of at least the preferred embodiments of the present invention is to provide a nitriding treatment method and a nitriding treatment apparatus in which a workpiece is heated quickly and uniformly up to a temperature at which a stable nitriding treatment can be performed, making it possible to apply the nitriding treatment in a state in which the workpiece temperature dispersion is scarcely caused.

A principal object at least the preferred embodiments of the present invention is to provide a nitriding treatment method and a nitriding treatment apparatus in which an extremely satisfactory nitriding treatment can be applied to a large number of workpieces having complicated shapes.

Another object of at least the preferred embodiments of the present invention is to provide a nitriding treatment method and a nitriding treatment apparatus which can be easily applied to different workpieces of many types.

Still another object of at least the preferred embodiments of the present invention is to provide a nitriding treatment method and a nitriding treatment apparatus in which a satisfactory nitriding treatment can be applied when the present invention is applied to a lateral type heat treatment furnace.

Still another object of at least the preferred embodiments of the present invention is to provide a nitriding treatment method and a nitriding treatment apparatus in which an extremely satisfactory nitriding treatment can be applied by managing the workpiece temperature highly accurately.

The invention provides a nitriding treatment method for performing a nitriding treatment for a workpiece in a heat treatment furnace, said nitriding treatment method comprising: a first step of applying a pulse voltage having a predetermined current density at a frequency of not less than 1 kHz between said heat treatment furnace and said workpiece to heat said workpiece by means of generated glow discharge, wherein said workpiece is heated by heat generated by said glow discharge and said heating element in this first step; and a second step of decreasing said current density of said pulse voltage after a temperature of said workpiece arrives at 350 °C, and then heating said workpiece up to a desired nitriding treatment temperature by using a heating element arranged around said workpiece, wherein heating is effected in this second step such that an amount of heat generated by said heating element is higher than that in said first step, wherein said nitriding treatment is performed by means of nitrogen ion or nitrogen radical generated by said glow discharge.

According to the this method, the pulse voltage, which is used to generate the glow discharge, is allowed to have a frequency of not less than 1 kHz. Accordingly, the period of time, in which the current is continuously applied, is not more than 1 ms, and the continuation of the arc discharge is avoided with a short detecting time. Thus, the current is cut off before arrival at a voltage at which any arc mark appears. Therefore, the stable glow discharge state can be maintained by avoiding the appearance of any arc mark, and it is possible to effect the heating without damaging the workpiece surface. It is preferable that the detecting time is shorter. Therefore, it is preferable that the power source to be used for generating the pulse voltage is, for example, those which operate at about 15 kHz. The workpiece is directly heated by the glow discharge, therefore the above method does not depend on, for example, the shape of the workpiece and the arrangement of the workpiece. In particular, it is possible to uniformly increase the workpiece temperature in the heat treatment furnace even in the case of a structure such as those of the lateral type heat treatment furnace in which any dispersion tends to appear depending on, for example, the convection current, the distance from the heating element, and the number of workpieces. The workpiece can be quickly heated in a state in which the uniform temperature distribution is maintained by using the glow discharge and the heating effected by the heating element together. As a result, the period of time, which is required for all workpieces to arrive at a certain temperature, is short. Further, it is possible to shorten the period of time which is required to retain the workpieces at the certain temperature as well.

The workpiece temperature may be detected during the heating, and the current density of the glow discharge is decreased after the temperature arrives at 350 °C. Accordingly, it is possible to avoid the generation of any excessive radiation heat from the workpiece itself heated by the glow discharge, it is possible to uniformly maintain the temperature distribution in the heat treatment furnace, and it is possible to avoid any sudden increase in temperature. Subsequently, when the workpiece is further heated from this temperature by using the heating element arranged around the workpiece, it is possible to set the workpiece at a desired nitriding treatment temperature highly accurately.

In this case, if the workpiece temperature exceeds the desired nitriding treatment temperature, it is feared that any abnormal microstructure is formed in the workpiece. However, in the above method, the heat generation, which is brought about by the glow discharge, can be adjusted highly accurately. Therefore, the workpiece can be set at a high temperature at which no overshoot occurs, and it is possible to shorten the period of time required for the nitriding treatment.

It is preferable that the current density of the glow discharge is 0.05 to 7 mA/cm$^2$. If the current density is less than 0.05 mA/cm$^2$, then the glow discharge is unstable especially at low temperatures, and it is impossible to perform the uniform heating. On the other hand, if the current density is larger than 7 mA/cm$^2$, then the transition to the arc discharge is caused, and any damage arises in the workpiece. If the current density is less than 0.1 mA/cm$^2$, a long period of time is required to raise the temperature. Further, if the current density exceeds 4 mA/cm$^2$, then ion collision tends to occur, for example, at projections when the workpiece has the projections or the like, and it is feared that the heating is advanced abnormally. Therefore, it is preferable that the current density is within a range of 0.1 to 4 mA/cm$^2$.

Further, in a preferred embodiment, in order to detect the workpiece temperature highly accurately without using any contact type thermometer, a dummy workpiece is arranged in the heat treatment furnace. The contact temperature and the radiation temperature of the dummy workpiece are detected, and the radiation temperature of the workpiece is detected. The radiation temperature of the workpiece is corrected on the basis of the difference in temperature between the contact temperature and the radiation temperature of the dummy workpiece to estimate the temperature of the workpiece itself. When the heating, which is effected by the glow discharge and the heating element, is controlled on the basis of the workpiece temperature estimated as described above, then the workpiece temperature can be managed highly accurately, and it is possible to perform the extremely satisfactory nitriding treatment.

Certain preferred embodiments of the present invention will now be described by way of example only and with reference to the accompanying drawings, in which:

> FIG. 1 shows a schematic arrangement of a nitriding treatment system including a nitriding treatment apparatus;
> FIG. 2 illustrates workpieces as objectives of the nitriding treatment and a magazine for accommodating the workpieces;
> FIG. 3 illustrates an arrangement of a lateral type heat treatment furnace and a control circuit thereof;
> FIG. 4 shows a flow chart illustrating a nitriding treatment method according to an embodiment of the present invention; and
> FIG. 5 illustrates the relationship among the workpiece temperature, the current density, and the heater output in the nitriding treatment method according to an embodiment of the present invention.

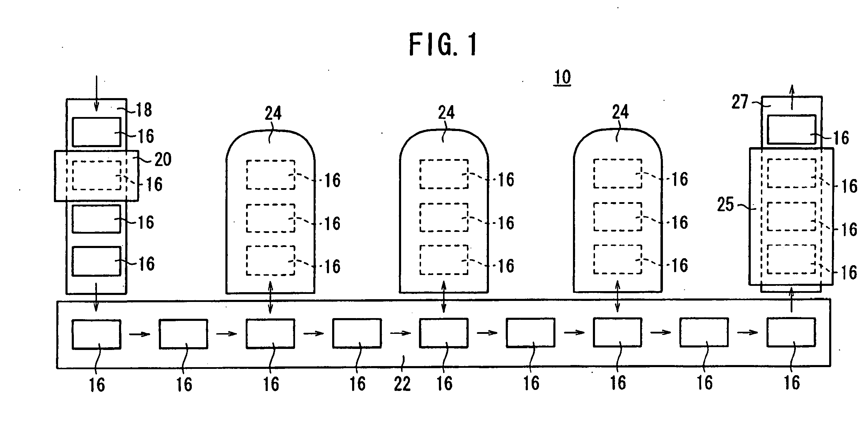

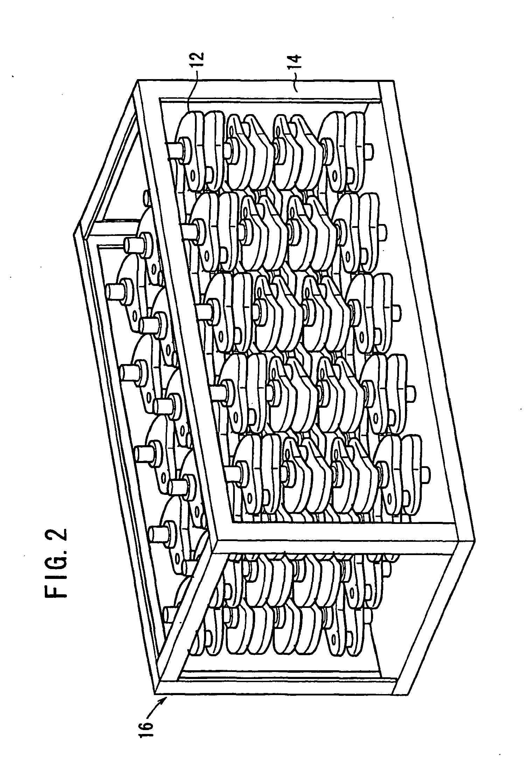

> FIG. 1 shows a schematic arrangement of a nitriding treatment system 10 including a nitriding treatment apparatus according to an embodiment of the present invention. As shown in FIG. 2, a plurality of crank shafts 12 as workpieces are supplied to the nitriding treatment system 10 in a form of a magazine 16 in which the plurality of crank shafts 12 are positioned with a jig 14.

The nitriding treatment system 10 comprises a washing machine 20 which removes, for example, dust and oil adhered to the crank shafts 12 transported by a conveyer 18, a conveyer 22 which receives the washed crank shafts 12 from the conveyer 18 to transport them to respective work stations, lateral type heat treatment furnaces 24 which are arranged at the plurality of work stations along the conveyer 22, and a cooling tank 25 which cools the crank shafts 12 transported by a conveyer 27 connected to the terminal end of the conveyer 22.

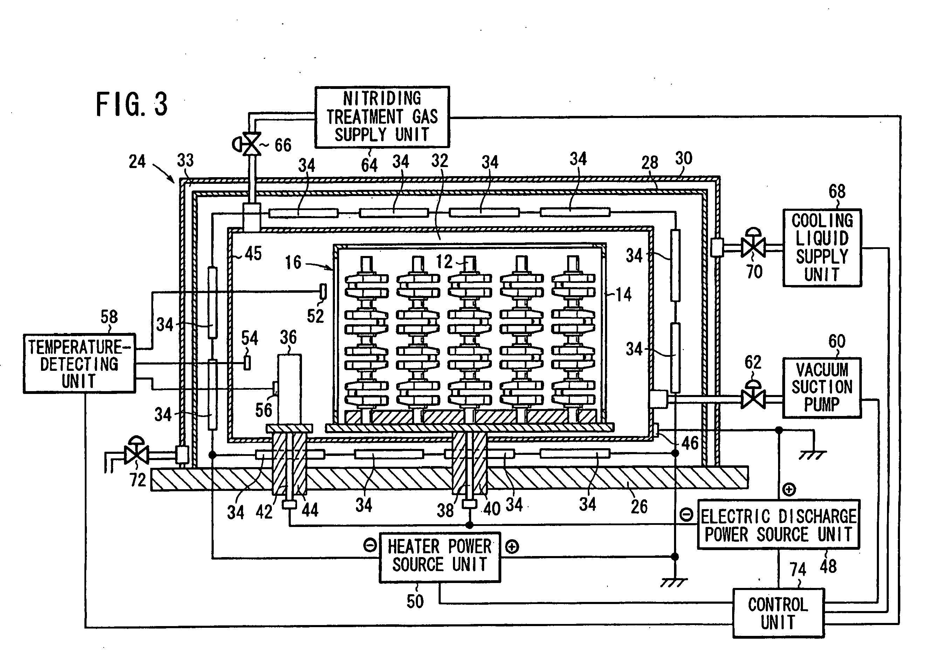

FIG. 3 illustrates an arrangement of the lateral type heat treatment furnace 24 and its control circuit arranged for each of the work stations.

The lateral type heat treatment furnace 24 is a heat treatment furnace for applying the plasma nitriding treatment to the crank shafts 12. The lateral type heat treatment furnace 24 is constructed as the lateral type. The magazine 16 with the positioned crank shafts 12 is placed into/out of the lateral type heat treatment furnace 24 in the horizontal direction. The lateral type heat treatment furnace 24 has an inner partition wall 28 and an outer partition wall 30 which are arranged on a base pedestal 26.

The inner partition wall 28 forms a nitriding treatment chamber 32 which involves a nitriding atmosphere for accommodating the crank shafts 12 together with the jig 14. The space, which is disposed between the inner partition wall 28 and the outer partition wall 30, forms a cooling liquid passage 33 for cooling the inner partition wall 28 to eliminate any influence of the heat radiation and facilitate the control when the temperature of the nitriding treatment chamber 32 is raised.

A plurality of electric heaters 34 (heating elements) are arranged along the inner partition wall 28 and the base pedestal 26 in the nitriding treatment chamber 32. A dummy workpiece 36, which has physical properties equivalent to those of the crank shaft 12, is arranged In the nitriding treatment chamber 32. The dummy workpiece 36 may be the crank shaft 12 itself.

A negative electrode 38, which is electrically connected to the magazine 16, is arranged for the base pedestal 26 by the aid of an insulator 40. Further, a negative electrode 42, which is electrically connected to the dummy workpiece 36, is arranged for the base pedestal 26 by the aid of an insulator 44. An electrode plate 45 is arranged at the inside of the electric heaters 34 of the nitriding treatment chamber 32. A positive electrode 46 is connected to the electrode plate 45. An electric discharge power source unit 48 (glow discharge-generating means), which applies a pulse voltage having a frequency of not less than 1 kHz, is connected between the negative electrodes 38, 42 and the positive electrode 46. A heater power source unit 50 (heating means) is connected to the electric heaters 34.

The nitriding treatment chamber 32 is arranged with a workpiece radiation thermometer 52 for detecting the radiation temperature of the crank shaft 12, a dummy workpiece radiation thermometer 54 for detecting the radiation temperature of the dummy workpiece 36, and a dummy workpiece contact thermometer 56 composed of a thermocouple fixed to the dummy workpiece 36 for detecting the contact temperature of the dummy workpiece 36. The workpiece radiation thermometer 52, the dummy workpiece radiation thermometer 54, and the dummy workpiece contact thermometer 56 are connected to a temperature-detecting unit 58 (temperature-detecting means, temperature-calculating means). The temperature-detecting unit 58 postulates or estimates the temperature of the crank shaft 12 from the respective detected temperature data.

A vacuum suction pump 60, which sucks the gas contained in the nitriding treatment chamber 32 to obtain a desired degree of vacuum, is connected to the nitriding treatment chamber 32 via a valve 62. A nitriding treatment gas supply unit 64, which supplies a gas for performing the plasma nitriding treatment, for example, a nitriding treatment gas as a mixed gas of nitrogen gas, hydrogen gas, ammonia gas, and argon gas into the nitriding treatment chamber 32, is connected to the nitriding treatment chamber 32 via a valve 66. A cooling liquid supply unit 68 for supplying the cooling liquid is connected to the cooling liquid passage 33 via a valve 70. The system is constructed such that the cooling liquid, which is supplied to the cooling liquid passage 33, is dischargeable to the outside via a valve 72.

The electric discharge power source unit 48, the heater power source unit 50, the temperature-detecting unit 58, the vacuum suction pump 60, the nitriding treatment gas supply unit 64, and the cooling liquid supply unit 68 are controlled by a control unit 74 (control means).

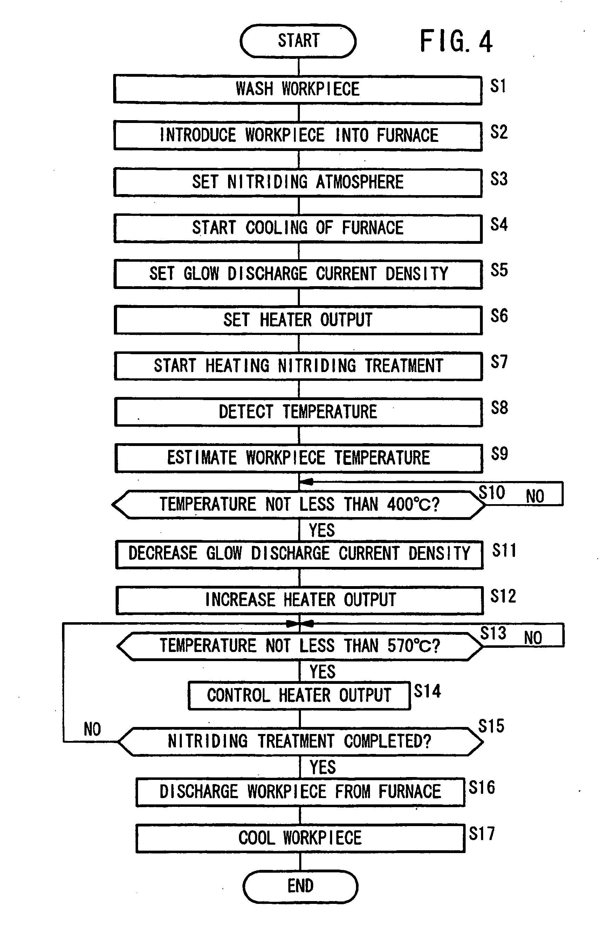

The nitriding treatment system 10 is basically constructed as described above. Next, its operation, function, and effect will be explained in accordance with a flow chart shown in FIG. 4.

At first, as shown in FIG. 2, the magazine 16, in which the plurality of crank shafts 12 are positioned in the jig 14, is prepared. The magazine 16 is placed into the washing machine 20 by using the conveyer 18 to remove dust and oil adhered to the respective crank shafts (Step S1).

Subsequently, the magazine 16, in which the crank shafts 12 have been washed, is transported by using the conveyer 22 to introduce the magazine 16 into the nitriding treatment chamber 32 of each of the lateral type heat treatment furnaces 24 (Step S2). In this arrangement, the lateral type heat treatment furnace 24 is of the horizontal type. Therefore, the following advantages are obtained as compared with the vertical type. That is, the plurality of magazines 16 retained with the crank shafts 12 can be easily placed into/out of the nitriding treatment chambers 32. Further, the layout of the nitriding treatment system 10 can be simplified. Furthermore, the number of the crank shafts 12 to be treated at once can be increased with ease. In contrast, in the case of the vertical type, it is necessary that the heat treatment chamber has a large size in the upward direction.

When the magazine 16 is introduced into the nitriding treatment chamber 32, the bottom of the jig 14 is connected to the negative electrode 38 arranged for the base pedestal 26. The dummy workpiece 36, which has the physical properties equivalent to those of the crank shaft 12, is previously arranged in the nitriding treatment chamber 32.

The nitriding treatment chamber 32 is set to have a nitriding atmosphere after introducing the magazine 16 into the nitriding treatment chamber 32 and tightly closing the lateral type heat treatment furnace 24 (Step S3). In this procedure, the control unit 74 is operated so that the vacuum suction pump 60 is driven to suck the air contained in the nitriding treatment chamber 32 until arrival at a predetermined degree of vacuum, and then the nitriding treatment gas supply unit 64 is driven to introduce, into the nitriding treatment chamber 32, the nitriding treatment gas composed of the mixed gas of, for example, nitrogen gas, hydrogen gas, ammonia gas, and argon gas.

Subsequently, the cooling liquid supply unit 68 is driven to introduce the cooling liquid into the cooling liquid passage 33 disposed between the inner partition wall 28 and the outer partition wall 30 and start the cooling of the wall surface of the inner partition wall 28 (Step S4). The control unit 74 sets the pulse voltage having a frequency of 15 kHz and a current density p of 2.5 mA/cm$^2$ for the electric discharge power source unit 48 (Step S5). Further, the control unit 74 sets the output H of the heater power source unit 50 to 40 % (Step S6). The heater power source unit 50 is operated at the maximum output (100 %) when the amount of electrical energy (thermal energy) of the crank shaft 12 introduced into the nitriding treatment chamber 32 is 160W per 1 kg. Thus, 40 % of the output H is 64W/kg.

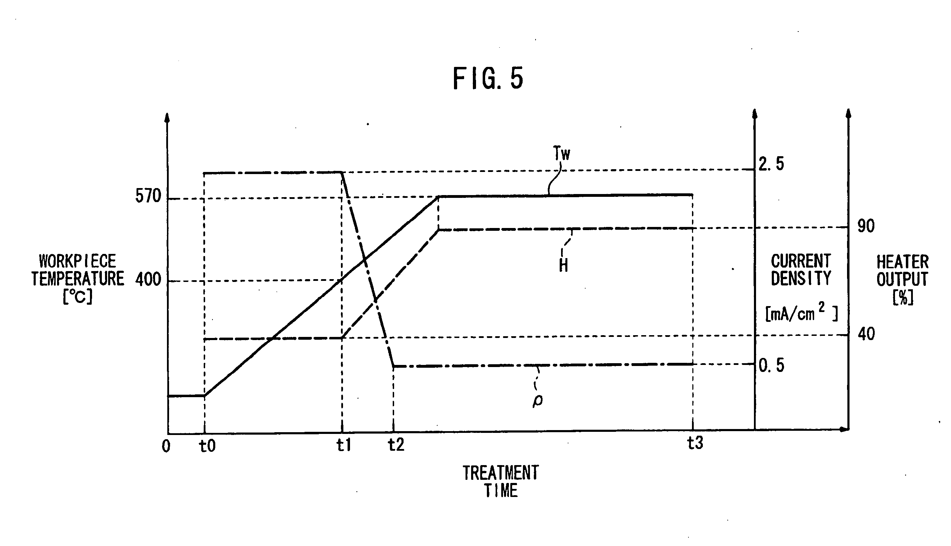

After setting the treatment conditions as described above, the heating of the nitriding atmosphere in the nitriding treatment chamber 32 and the nitriding treatment are started (Step S7). In this procedure, as shown in FIG. 5, when the crank shafts 12 are introduced, and the setting of the respective treatment conditions is completed to drive the electric discharge power source unit 48 and the heater power source unit 50 (treatment time to), then the glow discharge is generated by the pulse voltage applied between the negative electrode 38 and the positive electrode 46. The nitriding treatment gas in the nitriding treatment chamber 32 is ionized by the glow discharge to make the collision against the surfaces of the crank shafts 12. Accordingly, the crank shafts 12 are heated. Further, the electric heaters 34, which are arranged around the outer circumference of the magazine 16 for retaining the crank shafts 12, generate the heat, and the nitriding atmosphere of the nitriding treatment chamber 32 is heated by the radiation heat brought about by the heat generation. The glow discharge is also caused on the surface of the dummy workpiece 36. Therefore, the dummy workpiece 36 is also heated in the same manner as described above.

In this situation, the voltage having the pulse frequency of 15 kHz is applied between the negative electrodes 38, 42 and the positive electrode 46. Therefore, a stable glow discharge state, in which no arc discharge is caused, is maintained even in a state in which the nitriding atmosphere is not sufficiently subjected to the increase in temperature up to a temperature at which the stable nitriding treatment can be started. That is, the period of time, in which the current is continuously applied, is extremely short, and the continuation of the arc discharge is stopped with a short detecting time. Accordingly, the current is cut off before arrival at a voltage at which any arc mark appears. It is possible to avoid the appearance of any arc mark and maintain the stable glow discharge state. Therefore, any situation, in which the surface of the crank shaft 12 is damaged by the arc discharge, does not occur. The heating brought about by the glow discharge is not caused by the radiation heat but caused by the collision of nitrogen ions or nitrogen radicals produced by the glow discharge against the crank shafts 12. Therefore, when the temperature is less than 350 °C, then any influence is scarcely exerted by the radiation heat of the crank shafts 12, and no influence is exerted by the shapes of the crank shafts 12 and the positional relationship of the crank shafts 12 arranged adjacently to one another. Therefore, the crank shafts 12 are uniformly heated by the glow discharge. Further, the nitriding atmosphere of the nitriding treatment chamber 32 is heated by the radiation heat from the electric heaters 34 which are arranged along the inner partition wall 28 and which are set to provide the low output. Therefore, the crank shafts 12 are quickly heated up to the desired stable nitriding treatment temperature in the state in which the temperature distribution is uniformly maintained.

During the temperature-raising process, the cooling liquid is supplied to the cooling liquid passage 33. For example, when the inner partition wall 28 is cooled and maintained at a temperature of not more than 100 °C with the cooling liquid, it is possible to avoid such a situation that the radiation heat from the electric heaters 34 is reflected by the inner partition wall 28 to excessively heat the crank shafts 12 arranged inside. Therefore, it is possible to raise the temperature of the crank shaft 12 more uniformly.

On the other hand, the temperature of the crank shaft 12 is estimated highly accurately by using the temperature of the dummy workpiece 36 arranged in the nitriding treatment chamber 32 and the radiation temperature of the crank shaft 12 (Steps S8, S9).

That is, the workpiece radiation thermometer 52, which is arranged close to the crank shaft 12, detects the radiation temperature Trw as the temperature of the radiation heat radiated from the crank shaft 12. The dummy workpiece radiation thermometer 54, which is arranged close to the dummy workpiece 36, detects the radiation temperature Trd as the temperature of the radiation heat radiated from the dummy workpiece 36. Further, the dummy workpiece contact thermometer 56, which is fixed to the dummy workpiece 36, detects the correct contact temperature Tcd of the dummy workpiece 36.

Accordingly, the temperature-detecting unit 58 determines, as the temperature correction value AT, the difference between the radiation temperature Trd of the dummy workpiece 36 detected by the dummy workpiece radiation thermometer 54 and the contact temperature Tcd of the dummy workpiece 36 detected by the dummy workpiece contact thermometer 56 to calculate the temperature Tw of the crank shaft 12 by using the temperature correction value $\Delta T$ as follows:

$$Tw = Trw + \Delta T$$

When the temperature of the crank shaft 12 is calculated as described above, it is possible to highly accurately estimate the temperature Tw of the crank shaft 12 in a non-contact manner without fixing any thermometer such as a thermocouple to the crank shaft 12.

Subsequently, the control unit 74 executes the process for judging whether or not the temperature Tw of the crank shaft 12 estimated by the temperature-detecting unit 58 is not less than 400°C during the heating of the nitriding atmosphere of the nitriding treatment chamber 32 (Step S10). In this procedure, if the temperature Tw of the crank shaft 12 is not less than 400 °C, then it is impossible to ignore the influence of the heat radiation of the crank shaft 12 itself, and it is feared that any temperature unevenness appears on the crank shaft 12 if the heating by the glow discharge is continued as it is.

Accordingly, if it is judged that the temperature Tw of the crank shaft 12 arrives at 400 °C (treatment time t1), then the control unit 74 controls the electric discharge power source unit 48 to lower the current density $\rho$ of the glow discharge to be applied between the negative electrode 38 and the positive electrode 46 down to 0.5 mA/cm$^2$ (Step S11), and the output of the heater power source unit 50 is raised up to 90 %, i.e., 144kW\kg (Step S12).

In this procedure, when the current density $\rho$ is lowered down to 0.5 mA/cm$^2$, then it is possible to suppress such a situation that the radiation heat is radiated from the crank shaft 12 heated by the glow discharge, and it is possible to suppress any sudden heating which would be otherwise caused by the glow discharge of the crank shaft 12. When the output of the heater power source unit 50 is raised up to 90 %, it is possible to heat the crank shaft 12 up to the desired nitriding treatment temperature at which no overshoot is caused by the radiation heat from the electric heaters 34, in a state in which the temperature distribution of the crank shaft 12 is uniformly maintained. When the temperature of the crank shaft 12 is controlled by using the electric discharge power source unit 48 and the heater power source unit 50, for example, it is preferable to perform the following control. That is, the current density $\rho$ is gradually lowered from the treatment time t1 to the treatment time t2 in accordance with the temperature Tw of the crank shaft 12 estimated by the temperature-detecting unit 58, while the output of the heater power source unit 50 is gradually increased from the treatment time t1 until arrival at the desired nitriding treatment temperature of the crank shaft 12.

After the temperature Tw of the crank shaft 12 arrives at the desired nitriding treatment temperature of 570 °C (Step S13), the control unit 74 controls the heater power source unit 50 to maintain the temperature Tw of the crank shaft 12 at the nitriding treatment temperature of 570 °C (Step S14). During this process, the nitriding treatment is advanced on the surface of the crank shaft 12 in accordance with the reaction of nitrogen ion and iron ion.

When the predetermined period of time elapses, and the nitriding treatment is completed (Step S15, treatment time t3), then the crank shafts 12 are discharged from the lateral type heat treatment furnace 24 together with the magazine 16 (Step S16). The magazine 16, which has been discharged from the lateral type heat treatment furnace 24, is transported by the conveyer 22, and the magazine 16 is placed into the cooling tank 25 to perform the cooling treatment (Step S17). After that, the magazine 16 is discharged to the outside by the aid of the conveyer 27.

**Claims**

1. A nitriding treatment method for performing a nitriding treatment for a workpiece (12) in a heat treatment furnace (24), said nitriding treatment method comprising:

   a first step of applying a pulse voltage having a predetermined current density at a frequency of not less than 1 kHz between said heat treatment furnace (24) and said workpiece (12) to heat said workpiece (12) by means of generated glow discharge, wherein said workpiece (12) Is heated by heat generated by said glow discharge and said heating element (34) in this first step; and a second step of decreasing said current density of said pulse voltage after a temperature of said workpiece (12) arrives at 350 °C, and then heating said workpiece (12) up to a desired nitriding treatment temperature by using a heating element (34) arranged around said workpiece (12), wherein heating is effected in this second step such that an amount of heat generated by said heating element (34) is higher than that in said first step, wherein said nitriding treatment is performed by means of nitrogen ion or nitrogen radical generated by said glow discharge.

**2.** The nitriding treatment method according to claim 1, wherein said current density of said pulse voltage is gradually decreased in said second step, while said workpiece (12) is gradually heated up to said nitriding treatment temperature by using said heating element (34) arranged around said workpiece (12).

**3.** The nitriding treatment method according to claim 1, wherein said nitriding treatment temperature is maintained to execute said nitriding treatment after said workpiece (12) arrives at said desired nitriding treatment temperature in said second step.

**4.** The nitriding treatment method according to claim 1, wherein said current density of said pulse voltage is 0.05 to 7 mA/cm$^2$.

**5.** The nitriding treatment method according to claim 1, wherein said current density of said pulse voltage is 0.1 to 4 mA/cm$^2$.

**6.** The nitriding treatment method according to claim 1, wherein said temperature of said workpiece (12) is determined by detecting a temperature difference between a radiation temperature and a contact temperature of a dummy workpiece (36) arranged in said heat treatment furnace (24), detecting a radiation temperature of said workpiece (12), and correcting said radiation temperature of said workpiece (12) with said temperature difference.

**Patentansprüche**

**1.** Nitrierverfahren zum Durchfahren einer Nitrierbehandlung für ein Werkstück (12) in einem Wärmebehandlungsofen (24), wobei das Nitrierbehandlungsverfahren aufweist:

einen ersten Schritt des Anlegens einer Impulsspannung mit einer vorgegebenen Stromdichte mit einer Frequenz von nicht weniger als 1 kHz zwischen dem Wärmebehandlungsofen (24) und dem Werkstück (12), um das Werkstück (12) mit Hilfe der erzeugten Glimmentladung zu heizen, wobei das Werkstück (12) in diesem ersten Schritt durch Wärme geheizt wird, die durch die Glimmentladung und das Heizelement (34) erzeugt wird; und
einen zweiten Schritt des Verringerns der Stromdichte der Impulsspannung, nachdem eine Temperatur des Werkstücks (12) 350°C erreicht, und dann Heizen des Werkstücks (12) bis auf eine gewünschte Nitrierbehandlungstemperatur unter Verwendung eines Heizelements (34), das um das Werkstück (12) herum angeordnet ist, wobei das Heizen in diesem zweiten Schritt derart durchgeführt wird, dass eine von dem Heizelement (34) erzeugte Wärmemenge größer als in dem ersten Schritt ist, wobei die Nitrierbehandlung mittels Stickstoffionen oder Stickstoffradikalen durchgeführt wird, die durch die Glimmentladung erzeugt werden.

**2.** Nitrierverfahren nach Anspruch 1, wobei die Stromdichte der Impulsspannung in dem zweiten Schritt allmählich verringert wird, während das Werkstück (12) unter Verwendung des Heizelements (34), das um das Werkstück (12) herum angeordnet ist, allmählich bis auf die Nitrierbehandlungstemperatur geheizt wird.

**3.** Nitrierverfahren nach Anspruch 1, wobei die Nitrierbehandlungstemperatur in dem zweiten Schritt aufrecht erhalten wird, um die Nitrierbehandlung durchzuführen, nachdem das Werkstück (12) die gewünschte Nitriertemperatur erreicht hat.

**4.** Nitrierverfahren nach Anspruch 1, wobei die Stromdichte der Impulsspannung 0,05 bis 7 mA/cm$^2$ ist.

**5.** Nitrierverfahren nach Anspruch 1, wobei die Stromdichte der Impulsspannung 0,1 bis 4 mA/cm$^2$ ist.

**6.** Nitrierverfahren nach Anspruch 1, wobei die Temperatur des Werkstücks (12) bestimmt wird, indem eine Temperaturdifferenz zwischen einer Strahlungstemperatur und einer Kontakttemperatur eines in dem Wärmebehandlungsofen (24) angeordneten Testwerkstücks (36) bestimmt wird, wobei eine Strahlungstemperatur des Werkstücks (12) erfasst wird und die Strahlungstemperatur des Werkstücks (12) mit der Temperaturdifferenz korrigiert wird.

**Revendications**

**1.** Procédé de traitement de nitruration destiné à effectuer un traitement de nitruration pour une pièce de fabrication (12) dans un four de traitement thermique (24), ledit procédé de traitement de nitruration comprenant :

une première étape consistant à appliquer une tension d'impulsion ayant une densité de courant prédéterminée à une fréquence n'étant pas inférieure à 1 kHz entre ledit four de traitement thermique (24) et ladite pièce de fabrication (12) pour chauffer ladite pièce de fabrication (12) au moyen d'une décharge luminescente générée, dans lequel ladite pièce de travail (12) est chauffée par la chaleur générée par ladite décharge luminescente et ledit élément chauffant (34) dans cette première étape ; et
une seconde étape consistant à réduire ladite densité de courant de ladite tension d'impulsion après qu'une température de ladite pièce de fabrication (12) arrive à 350°C, et puis à chauffer ladite pièce de fabrication (12) jusqu'à une température de traitement de nitruration souhaitée en utilisant un élément chauffant (34) disposé autour de ladite pièce de fabrication (12), dans lequel le chauffage est effectué dans cette seconde étape de sorte qu'une quantité de chaleur générée par ledit élément chauffant (34) est supérieure à celle dans ladite première étape, dans lequel

ledit traitement de nitruration est effectué au moyen d'un ion d'azote ou d'un radical d'azote généré par ladite décharge luminescente.

2. Procédé de traitement de nitruration selon la revendication 1, dans lequel ladite densité de courant de ladite tension d'impulsion est réduite progressivement dans ladite seconde étape, alors que ladite pièce de fabrication (12) est progressivement chauffée jusqu'à ladite température de traitement de nitruration en utilisant ledit élément chauffant (34) disposé autour de ladite pièce de fabrication (12).

3. Procédé de traitement de nitruration selon la revendication 1, dans lequel ladite température de traitement de nitruration est maintenue pour exécuter ledit traitement de nitruration après que ladite pièce de fabrication (12) arrive à ladite température de traitement de nitruration souhaitée dans ladite seconde étape.

4. Procédé de traitement de nitruration selon la revendication 1, dans lequel ladite densité de courant de ladite tension d'impulsion est de 0,05 à 7 mA/cm$^2$.

5. Procédé de traitement de nitruration selon la revendication 1, dans lequel ladite densité de courant de ladite tension d'impulsion est de 0,1 à 4 mA/cm$^2$.

6. Procédé de traitement de nitruration selon la revendication 1, dans lequel ladite température de ladite pièce de fabrication (12) est déterminée en détectant une différence de température entre une température de rayonnement et une température de contact d'une pièce de fabrication factice (36) disposée dans ledit four de traitement thermique (24), en détectant une température de rayonnement de ladite pièce de fabrication (12), et en corrigeant ladite température de rayonnement de ladite pièce de fabrication (12) avec ladite différence de température.

# FIG. 1

<u>10</u>

FIG. 2

FIG. 3

NITRIDING TREATMENT GAS SUPPLY UNIT

COOLING LIQUID SUPPLY UNIT

TEMPERATURE-DETECTING UNIT

VACUUM SUCTION PUMP

ELECTRIC DISCHARGE POWER SOURCE UNIT

HEATER POWER SOURCE UNIT

CONTROL UNIT

EP 1 640 470 B1

# FIG. 4

```
                    ( START )

┌─────────────────────────────────────────┐
│           WASH WORKPIECE                 │ S1
└─────────────────────────────────────────┘
┌─────────────────────────────────────────┐
│    INTRODUCE WORKPIECE INTO FURNACE      │ S2
└─────────────────────────────────────────┘
┌─────────────────────────────────────────┐
│        SET NITRIDING ATMOSPHERE          │ S3
└─────────────────────────────────────────┘
┌─────────────────────────────────────────┐
│        START COOLING OF FURNACE          │ S4
└─────────────────────────────────────────┘
┌─────────────────────────────────────────┐
│     SET GLOW DISCHARGE CURRENT DENSITY   │ S5
└─────────────────────────────────────────┘
┌─────────────────────────────────────────┐
│           SET HEATER OUTPUT              │ S6
└─────────────────────────────────────────┘
┌─────────────────────────────────────────┐
│    START HEATING NITRIDING TREATMENT     │ S7
└─────────────────────────────────────────┘
┌─────────────────────────────────────────┐
│          DETECT TEMPERATURE              │ S8
└─────────────────────────────────────────┘
┌─────────────────────────────────────────┐
│     ESTIMATE WORKPIECE TEMPERATURE       │ S9
└─────────────────────────────────────────┘

< TEMPERATURE NOT LESS THAN 400°C? >  S10  NO
              │ YES
┌─────────────────────────────────────────┐
│ DECREASE GLOW DISCHARGE CURRENT DENSITY  │ S11
└─────────────────────────────────────────┘
┌─────────────────────────────────────────┐
│         INCREASE HEATER OUTPUT           │ S12
└─────────────────────────────────────────┘

< TEMPERATURE NOT LESS THAN 570°C? >  S13  NO
              │ YES
┌─────────────────────────────┐
│    CONTROL HEATER OUTPUT     │ S14
└─────────────────────────────┘

NO  < NITRIDING TREATMENT COMPLETED? >  S15
              │ YES
┌─────────────────────────────────────────┐
│    DISCHARGE WORKPIECE FROM FURNACE      │ S16
└─────────────────────────────────────────┘
┌─────────────────────────────────────────┐
│           COOL WORKPIECE                 │ S17
└─────────────────────────────────────────┘

                    ( END )
```

## FIG. 5

WORKPIECE TEMPERATURE [°C]

CURRENT DENSITY [mA/cm²]

HEATER OUTPUT [%]

Tw

H

ρ

570

400

2.5

90

40

0.5

0    t0              t1    t2                              t3

TREATMENT TIME

EP 1 640 470 B1

**EP 1 640 470 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 52082641 A
- JP 53023836 A
- US 4309227 A